(19) Europäisches Patentamt
European Patent Office
Office européen des brevets

(11) **EP 4 327 110 B1**

(12) # EUROPEAN PATENT SPECIFICATION

(45) Date of publication and mention
of the grant of the patent:
**12.02.2025  Bulletin 2025/07**

(21) Application number: **22730169.4**

(22) Date of filing: **20.05.2022**

(51) International Patent Classification (IPC):
**G01R 27/26** *(2006.01)*    **G01R 31/42** *(2006.01)*
**G01R 31/64** *(2020.01)*    **H02H 3/353** *(2006.01)*
**H02H 7/16** *(2006.01)*

(52) Cooperative Patent Classification (CPC):
**G01R 27/2605; G01R 31/42; G01R 31/64;
H02H 3/353;** Y02E 40/50

(86) International application number:
**PCT/EP2022/063696**

(87) International publication number:
**WO 2022/248351 (01.12.2022 Gazette 2022/48)**

(54) **DETERMINING METHOD AND APPARATUS FOR WORKING VOLTAGE OF ISOLATED NEUTRAL SYSTEM**

BESTIMMUNGSVERFAHREN UND VORRICHTUNG FÜR DIE ARBEITSSPANNUNG EINES ISOLIERTEN NEUTRALEN SYSTEMS

PROCÉDÉ ET APPAREIL DE DÉTERMINATION DE TENSION DE FONCTIONNEMENT D'UN RÉSEAU À NEUTRE ISOLÉ

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **24.05.2021  CN 202110567792**

(43) Date of publication of application:
**28.02.2024  Bulletin 2024/09**

(73) Proprietor: **Siemens Aktiengesellschaft
80333 München (DE)**

(72) Inventors:
• **LIAN, Hai Tao**
**Nanjing, Jiangsu 211100 (CN)**
• **WANG, Fei**
**Nanjing, Jiangsu 211100 (CN)**
• **MEI, Hui Nan**
**Nanjing, Jiangsu 211100 (CN)**
• **SHEN, Liang**
**Nanjing, Jiangsu 211106 (CN)**

(74) Representative: **Horn Kleimann Waitzhofer
Schmid-Dreyer
Patent- und Rechtsanwälte PartG mbB
Theresienhöhe 12
80339 München (DE)**

(56) References cited:
• **JOUYBARI-MOGHADDAM HESSAMODDIN ET AL: "Shunt Capacitor Banks Online Monitoring Using a Superimposed Reactance Method", IEEE TRANSACTIONS ON SMART GRID, IEEE, USA, vol. 9, no. 6, 1 November 2018 (2018-11-01), pages 5554 - 5563, XP011693388, ISSN: 1949-3053, [retrieved on 20181018], DOI: 10.1109/ TSG.2017.2690643**
• **TERRENCE SMITH: "Determining settings for capacitor bank protection", PROTECTIVE RELAY ENGINEERS, 2010 63RD ANNUAL CONFERENCE FOR, IEEE, PISCATAWAY, NJ, USA, 29 March 2010 (2010-03-29), pages 1 - 9, XP031679149, ISBN: 978-1-4244-6073-1**

**(Cont. next page)**

- BOGDAN KASZTENNY ET AL: "Fundamentals of adaptive protection of large capacitor banks", POWER SYSTEMS CONFERENCE: ADVANCED METERING, PROTECTION, CONTROL, COMMUNICATION, AND DISTRIBUTED RESOURCES, 2007. PSC 2007, IEEE, PISCATAWAY, NJ, USA, 13 March 2007 (2007-03-13), pages 154 - 186, XP031403295, ISBN: 978-1-4244-0854-2

**Description**

TECHNICAL FIELD

The present invention relates to the field of power systems, and in particular, to a determining method and apparatus for a working voltage of an isolated neutral system.

BACKGROUND ART

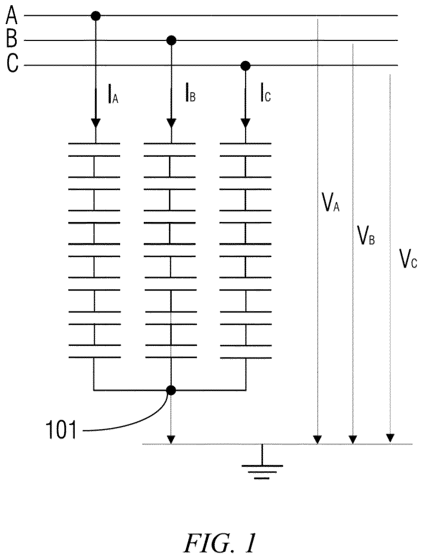

In an isolated neutral system, a neutral point in a three-phase alternating current grid is not electrically connected to earth, that is, isolated neutral means that the neutral point is not manually connected to earth. FIG. 1 is a schematic structural diagram of an isolated neutral system. The system includes three phase wires and three capacitor banks, where the three phase wires are respectively a phase-A wire, a phase-B wire, and a phase-C wire, and the three capacitor banks are respectively a capacitor bank 14 on the phase-A wire, a capacitor bank 15 on the phase-B wire, and a capacitor bank 16 on the phase-C wire. One terminal of each capacitor bank is connected to one phase wire, and the respective other terminals of the capacitor banks are connected to one another to form a neutral point 101. Each capacitor bank includes a plurality of capacitors connected in series and/or in parallel. When a capacitance value of each capacitor bank is equal, that is, when $C_A = C_B = C_C$, a sampling value of a phase voltage of each phase wire is equal, where $C_A$ denotes a capacitance value of the phase-A wire, $C_B$ denotes a capacitance value of the phase-B wire, $C_C$ denotes a capacitance value of the phase-C wire, $I_A$ denotes a current of the phase-A wire, $I_B$ denotes a current of the phase-B wire, and $I_C$ denotes a current of the phase-C wire. In this case, a working voltage of the isolated neutral system is 0.

However, in actual application, due to process errors or breakdowns of small internal capacitors or other factors, capacitance values of the capacitors may not be consistent with a preset value, and it is not easy to measure a capacitance value of each capacitor. This may cause a case where the working voltage of the isolated neutral system exceeds a preset threshold when no fault occurs, further causing a relay protection apparatus corresponding to the capacitor bank to perform a false action.

Jouybari-Moghaddam Hessamoddin et al.: "Shunt Capacitor Banks Online Monitoring Using a Superimposed Reactance Method', IEEE Transactions on Smart Grid discloses that a neutral voltage will shift when an element develops a fault in a neutral system. It suggests calculating respective reactance values.

Terrence Smith: "Determining settings for capacitor bank protection", Protective Relay Engineers, 2010 discloses that in order to calculate the voltage caused by capacitance differences, Kirchhoff's current law for the neutral point should be considered.

Bogdan Kasztenny et al.: "Fundamentals of adaptiveprotection of large capacitor banks", Power Systems Conference: Advanced Metering, Protection, Control, Communication, And Distributed Resources discloses that shunt Capacitor Banks (SCB) are installed to provide capacitive reactive compensation and power factor correction. The use of SCBs has increased because they are relatively inexpensive, easy and quick to install, and can be deployed virtually anywhere in the grid.

SUMMARY OF THE INVENTION

In view of this, the present invention proposes a determining method for a working voltage of an isolated neutral system, where a power system includes three phase wires and three capacitor banks, one terminal of each capacitor bank is connected to one phase wire, the respective other terminals of the capacitor banks are connected to one another to form a neutral point, and each capacitor bank includes a plurality of capacitors; and the determining method includes:

periodically sampling a phase voltage of each phase wire, to obtain a plurality of groups of sampling values of real-time phase voltages, where each group of sampling values of real-time phase voltages includes a sampling value of a phase voltage of each phase wire that is obtained by simultaneously measuring each phase wire;
determining unbalance rates between the capacitor banks based on the plurality of groups of sampling values of real-time phase voltages, where the unbalance rate is a ratio between capacitance values of every two phase wires; and
determining a working voltage of the isolated neutral system based on the unbalance rates.

According to the determining method as described above, the step of determining unbalance rates between the capacitor banks based on the plurality of groups of sampling values of real-time phase voltages includes:
determining unbalance rates $K_{AB}$ and $K_{AC}$ between the capacitor banks based on the following formula:

$$R=\left( \quad X'X \right)^{-1} X' Y$$

$$X = \begin{bmatrix} x_{11} & x_{21} \\ x_{12} & x_{22} \\ x_{13} & x_{23} \\ \cdots & \cdots \\ x_{1n} & x_{2n} \end{bmatrix}, \quad Y = \begin{bmatrix} y_1 \\ y_2 \\ y_3 \\ \cdots \\ y_n \end{bmatrix}, \quad R = \begin{bmatrix} K_{AB} \\ K_{AC} \end{bmatrix}$$

where , $x_{1n}$ denotes a value of $x_1$ obtained in the $n^{th}$ measurement, $x_{2n}$ denotes a value of $x_2$ obtained in the $n^{th}$ measurement, $y_n$ denotes a value of $y$ obtained in the $n^{th}$ measurement, $x_1 = (V_X - V_B)$, $x_2 = (V_X - V_C)$, $y = V_A - V_X$, $V_X$ denotes a sampling value of a zero sequence voltage of the neutral point, $V_A$ denotes a sampling value of a phase voltage of a phase-A wire, $V_B$ denotes a sampling value of a phase voltage of a phase-B wire, $V_C$ denotes a sampling value of a phase voltage of a phase-C wire,

$$K_{AB} = \frac{c_B}{c_A} \quad K_{AC} = \frac{c_C}{c_A}$$

, $C_A$ denotes a capacitance value of the phase-A wire, $C_B$ denotes a capacitance value of the phase-B wire, and $C_C$ denotes a capacitance value of the phase-C wire.

According to the determining method as described above, optionally, the working voltage is

$$\frac{1}{3}|V_X(1 + K_{AB} + K_{AC}) - 3V_0 + V_B(1 - K_{AB}) + V_C(1 - K_{AC})|$$, and

$$V_0 = (V_A + V_B + V_C)/3$$.

According to the determining method as described above, optionally, the number of groups of sampling values of real-time phase voltages ranges from 2 to 10.

According to the determining method as described above, optionally, after the step of determining a working voltage of the isolated neutral system based on the unbalance rates, the determining method further includes:

if it is identified that a fault occurs in the isolated neutral system, determining, based on the working voltage, whether the fault is an internal fault, where the internal fault indicates that a fault occurs in a capacitor in the capacitor bank; and the step of determining, based on the working voltage, whether the fault is an internal fault includes:
if a value of the working voltage is greater than or equal to a preset threshold, determining that the fault is an internal fault.

The present invention further provides a determining apparatus for a working voltage of an isolated neutral system, where a power system includes three phase wires and three capacitor banks, one terminal of each capacitor bank is connected to one phase wire, the respective other terminals of the capacitor banks are connected to one another to form a neutral point, and each capacitor bank includes a plurality of capacitors; and the determining apparatus includes:

a sampling unit configured to periodically sample a phase voltage of each phase wire, to obtain a plurality of groups of sampling values of real-time phase voltages, where each group of sampling values of real-time phase voltages includes a sampling value of a phase voltage of each phase wire that is obtained by simultaneously measuring each phase wire;
a first determining unit configured to determine unbalance rates between the capacitor banks based on the plurality of groups of sampling values of real-time phase voltages, where the unbalance rate is a ratio between capacitance values of every two phase wires; and
a second determining unit configured to determine a working voltage of the isolated neutral system based on the unbalance rates.

According to the determining apparatus as described above, the first determining unit is specifically configured to:

determine unbalance rates $K_{AB}$ and $K_{AC}$ between the capacitor banks

based on the following formula:

$$R = (\quad X'X)^{-1}\,X'\,Y$$

$$X = \begin{bmatrix} x_{11} & x_{21} \\ x_{12} & x_{22} \\ x_{13} & x_{23} \\ \cdots & \cdots \\ x_{1n} & x_{2n} \end{bmatrix}$$ where $$X = \begin{bmatrix} x_{11} & x_{21} \\ x_{12} & x_{22} \\ x_{13} & x_{23} \\ \cdots & \cdots \\ x_{1n} & x_{2n} \end{bmatrix}$$ $$Y = \begin{bmatrix} y_1 \\ y_2 \\ y_3 \\ \cdots \\ y_n \end{bmatrix}$$ $$R = \begin{bmatrix} K_{AB} \\ K_{AC} \end{bmatrix}$$ , $x_{1n}$ denotes a value of $x_1$ obtained in the $n^{th}$ measurement, $x_{2n}$ denotes a value of $x_2$ obtained in the $n^{th}$ measurement, $y_n$ denotes a value of $y$ obtained in the $n^{th}$ measurement, $x_1 = (V_X - V_B)$, $x_2 = (V_X - V_C)$ $y = V_A - V_X$, $V_X$ denotes a sampling value of a zero sequence voltage of the neutral point, $V_A$ denotes a sampling value of a phase voltage of a phase-A wire, $V_B$ denotes a sampling value of a phase voltage of a phase-B wire, $V_C$ denotes a sampling value of a phase voltage of a phase-C wire,

$$K_{AB} = \frac{C_B}{C_A}, \quad K_{AC} = \frac{C_C}{C_A}$$ , $C_A$ denotes a capacitance value of the phase-A wire, $C_B$ denotes a capacitance value of the phase-B wire, and $C_C$ denotes a capacitance value of the phase-C wire.

According to the determining apparatus as described above, optionally, the working voltage is

$$\frac{1}{3}\left| V_X(1 + K_{AB} + K_{AC}) - 3V_0 + V_B(1 - K_{AB}) + V_C(1 - K_{AC}) \right|$$ , and $V_0 = (V_A + V_B + V_C)/3$.

According to the determining apparatus as described above, optionally, the number of groups of sampling values of real-time phase voltages ranges from 2 to 10.

According to the determining apparatus as described above, optionally, the determining apparatus further includes:

a third determining unit configured to: if it is identified that a fault occurs in the isolated neutral system, determine, based on the working voltage, whether the fault is an internal fault, where the internal fault indicates that a fault occurs in a capacitor in the capacitor bank; and
the step of determining, based on the working voltage, whether the fault is an internal fault includes:
if a value of the working voltage is greater than or equal to a preset threshold, determining that the fault is an internal fault.

The present invention further provides a determining apparatus for a working voltage of an isolated neutral system, where a power system includes three phase wires and three capacitor banks, one terminal of each capacitor bank is connected to one phase wire, the respective other terminals of the capacitor banks are connected to one another to form a neutral point, and each capacitor bank includes a plurality of capacitors; and the determining apparatus includes:
at least one memory configured to store instructions; and
at least one processor configured to perform, according to the instructions stored in the memory, the determining method for a working voltage of an isolated neutral system according to any one of the foregoing embodiments.

The present invention further provides a readable storage medium, where the readable storage medium stores machine-readable instructions that, when executed by a machine, cause the machine to perform the determining method for a working voltage of an isolated neutral system according to any one of the foregoing embodiments.

The unbalance rates between the capacitor banks are obtained based on the sampling values of the phase voltages measured in real time, and the working voltage is accurately determined based on the unbalance rates, so that subsequent operations can be accurately performed.

BRIEF DESCRIPTION OF THE DRAWINGS

The above and other features and advantages of the present invention will be more apparent to those of ordinary skill in the art from the detailed description of preferred embodiments of the present invention with reference to the accompanying drawings, in which:

FIG. 1 is a schematic structural diagram of an isolated neutral system according to an embodiment of the present invention;

FIG. 2 is a schematic flowchart of a determining method for a working voltage of an isolated neutral system according to another embodiment of the present invention;

FIG. 3 is a schematic flowchart of a determining method for a working voltage of an isolated neutral system according to still another embodiment of the present invention;

FIG. 4A is a schematic structural diagram of a determining apparatus for a working voltage of an isolated neutral system according to an embodiment of the present invention; and

FIG. 4B is a schematic structural diagram of a determining apparatus for a working voltage of an isolated neutral system according to another embodiment of the present invention.

DETAILED DESCRIPTION OF EMBODIMENTS

In order to make the objectives, technical solutions, and advantages of the present invention more apparent, the present invention will be described in further detail by way of embodiments hereinafter.

Faults occurring in an isolated neutral system may be classified as an internal fault and an external fault. The internal fault indicates that a fault such as an earth fault or a capacitor breakdown occurs in a capacitor bank of the isolated neutral system. The external fault indicates that a fault does not occur in a capacitor, but occurs in a device beyond the protection of a relay protection apparatus corresponding to the capacitor bank. When the external fault occurs, the relay protection apparatus corresponding to the capacitor bank should not perform an action. Whether the relay protection apparatus should perform an action may be determined by determining whether a working voltage exceeds a preset threshold. If the working voltage is greater than or equal to the preset threshold, protection should be activated. If the working voltage is less than the preset threshold, no action should be performed. Therefore, accuracy of the working voltage plays a key role. The inventor found that the working voltage is related to a ratio between capacitor banks, and based on this, the inventor provides a method for determining a ratio between capacitor banks, to obtain an accurate working voltage.

Embodiment 1

This embodiment provides a determining method for a working voltage of an isolated neutral system, and the method is performed by a determining apparatus for a working voltage of an isolated neutral system. The apparatus may be integrated into a relay protection apparatus, or may be independently disposed.

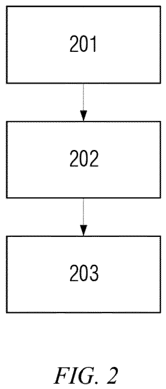

FIG. 2 is a schematic flowchart of the determining method for a working voltage of an isolated neutral system according to this embodiment. The determining method for a working voltage of an isolated neutral system includes the following steps.

In step 201, a phase voltage of each phase wire is periodically sampled, to obtain a plurality of groups of sampling values of real-time phase voltages, where each group of sampling values of real-time phase voltages includes a sampling value of a phase voltage of each phase wire that is obtained by simultaneously measuring each phase wire.

A phase voltage of each phase wire is continuously sampled periodically, and a period may be set according to actual requirements, for example, may be set to one millisecond. In addition, each phase wire is simultaneously sampled. Specifically, a sampling value of a phase voltage may be obtained by using a voltage sensor.

The number of groups of sampling values of real-time phase voltages may range from 2 to 10. In this way, enough data can be provided to accurately determine the working voltage subsequently and the working voltage can be determined as quickly as possible.

In step 202, unbalance rates between the capacitor banks are determined based on the plurality of groups of sampling values of real-time phase voltages, where the unbalance rate is a ratio between capacitance values of every two phase wires.

Due to process errors or other factors, a capacitance value of each capacitor bank may not be equal, and it is very difficult to measure a capacitance value of each capacitor in each capacitor bank. The inventor uses a manner of determining a ratio between capacitance values of the capacitor banks based on a sampling value of a real-time phase voltage to determine the working voltage with higher accuracy.

For example, unbalance rates $K_{AB}$ and $K_{AC}$ between the capacitor banks are determined based on the following formula:

$$R = (\quad X^{'}X)^{-1} X^{'} Y$$

$$X = \begin{bmatrix} x_{11} & x_{21} \\ x_{12} & x_{22} \\ x_{13} & x_{23} \\ \cdots & \cdots \\ x_{1n} & x_{2n} \end{bmatrix}, \quad Y = \begin{bmatrix} y_1 \\ y_2 \\ y_3 \\ \cdots \\ y_n \end{bmatrix}, \quad R = \begin{bmatrix} K_{AB} \\ K_{AC} \end{bmatrix}$$

where , $x_{1n}$ denotes a value of $x_1$ obtained in the $n^{th}$ measurement, $x_{2n}$ denotes a value of $x_2$ obtained in the $n^{th}$ measurement, $y_n$ denotes a value of y obtained in the $n^{th}$ measurement, $x_1 = (V_X - V_B)$, $x_2 = (V_X - V_C)$, $y = V_A - V_X$, $V_X$ denotes a sampling value of a zero sequence voltage of the neutral point, $V_A$ denotes a sampling value of a phase voltage of a phase-A wire, $V_B$ denotes a sampling value of a phase voltage of a phase-B wire, $V_C$ denotes a sampling value of a phase voltage of a phase-C wire,

$$K_{AB} = \frac{c_B}{c_A}, \quad K_{AC} = \frac{c_C}{c_A}$$

, $C_A$ denotes a capacitance value of the phase-A wire, $C_B$ denotes a capacitance value of the phase-B wire, and $C_C$ denotes a capacitance value of the phase-C wire.

In step 203, the working voltage of the isolated neutral system is determined based on the unbalance rate.

The working voltage may be defined according to requirements, for example, may be configured based on a corresponding relay protection apparatus. In the present invention, the working voltage is, for example,

$$\left| V_X(1 + K_{AB} + K_{AC}) - 3V_0 + V_B(1 - K_{AB}) + V_C(1 - K_{AC}) \right|,$$

where

$$K_{AB} = \frac{c_B}{c_A}, \quad K_{AC} = \frac{c_C}{c_A}$$

$V_0 = (V_A + V_B + V_C)/3$, , , $C_A$ denotes a capacitance value of the phase-A wire, $C_B$ denotes a capacitance value of the phase-B wire, and $C_C$ denotes a capacitance value of the phase-C wire.

Optionally, after step 203, the determining method further includes: returning to perform step 201, and periodically repeating the foregoing steps, to continuously determine a sampling value of a phase voltage. In this embodiment, working personnel may trigger step 201 according to actual requirements, or steps 201 to 203 may be periodically performed by the apparatus to automatically determine the working voltage.

Optionally, after step 203, the determining method further includes: if it is identified that a fault occurs in the isolated neutral system, determining, based on the working voltage, whether the fault is an internal fault, where the internal fault indicates that a fault occurs in a capacitor in the capacitor bank. If it is determined that the fault is an internal fault, a relay protection apparatus corresponding to the capacitor bank should perform an action to clear the fault. If it is determined that the fault is a non-internal fault, that is, it is determined that the fault is an external fault, the relay protection apparatus corresponding to the capacitor bank should not perform an action. As an exemplary description, if a value of the working voltage is less than a preset threshold, it is determined that the fault is an external fault. If the value of the working voltage is greater than or equal to the preset threshold, it is determined that the fault is an internal fault. The preset threshold herein may be determined according to actual requirements, and details are not repeated herein.

In this embodiment, the unbalance rates between the capacitor banks are obtained based on the sampling values of the phase voltages measured in real time, and the working voltage is accurately determined based on the unbalance rates, so that subsequent operations can be accurately performed.

Embodiment 2

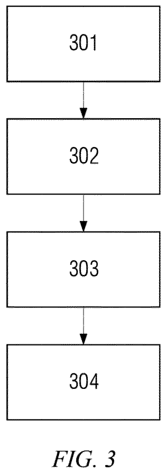

This embodiment further supplements the descriptions of the determining method for a working voltage of an isolated neutral system in Embodiment 1. FIG. 3 is a schematic flowchart of the determining method for a working voltage of an isolated neutral system according to this embodiment. The determining method for a working voltage of an isolated neutral system includes the following steps.

In step 301, when it is determined that a fault occurs in a capacitor bank, a phase voltage of each phase wire is periodically sampled, to obtain a plurality of groups of sampling values of real-time phase voltages, where each group of sampling values of real-time phase voltages includes a sampling value of a phase voltage of each phase wire that is obtained by simultaneously measuring each phase wire.

Specific operations of step 301 are consistent with those of step 201, and details are not repeated herein.

Herein, the number of groups of sampling values of real-time phase voltages may range from 2 to 10, and the number of 5 groups may be specifically selected.

In step 302, unbalance rates $K_{AB}$ and $K_{AC}$ between the capacitor banks are de-termined based on the following

formula:

$$R=(\quad X'X)^{-1}\, X'\, Y$$

where ,
$$X = \begin{bmatrix} x_{11} & x_{21} \\ x_{12} & x_{22} \\ x_{13} & x_{23} \\ \cdots & \cdots \\ x_{1n} & x_{2n} \end{bmatrix} \quad Y = \begin{bmatrix} y_1 \\ y_2 \\ y_3 \\ \cdots \\ y_n \end{bmatrix} \quad R = \begin{bmatrix} K_{AB} \\ K_{AC} \end{bmatrix}$$
, $x_{1n}$ denotes a value of $x_1$ obtained in the $n^{th}$ measurement, $x_{2n}$ denotes a value of $x_2$ obtained in the $n^{th}$ measurement, $y_n$ denotes a value of $y$ obtained in the $n^{th}$ measurement, $x_1 = (V_X - V_B)$, $x_2 = (V_X - V_C)$, $y = V_A - V_X$, $V_X$ denotes a sampling value of a zero sequence voltage of the neutral point of the isolated neutral system, $V_A$ denotes a sampling value of a phase voltage of a phase-A wire, $V_B$ denotes a sampling value of a phase voltage of a phase-B wire, $V_C$ denotes a sampling value of a phase voltage of a phase-C wire,

$$K_{AB} = \frac{C_B}{C_A}, \quad K_{AC} = \frac{C_C}{C_A}$$
$C_A$ denotes a capacitance value of the phase-A wire, $C_B$ denotes a capacitance value of the phase-B wire, and $C_C$ denotes a capacitance value of the phase-C wire.

This is because, for the isolated neutral system whose capacitor bank is not faulty, that is, for the isolated neutral system where sampling values of phase voltages of the three phase wires are equal, a sum of currents of the three phase wires is 0, that is:

$$I_A + I_B + I_C = j\omega C_A(V_A - V_X) + j\omega C_B(V_B - V_X) + j\omega C_C(V_C - V_X) = 0 \qquad (1.1)$$

where $I_A$ denotes a current of the phase-A wire, $I_B$ denotes a current of the phase-B wire, $I_C$ denotes a current of the phase-C wire, $V_A$ denotes a sampling value of a phase voltage of the phase-A wire, $V_B$ denotes a sampling value of a phase voltage of the phase-B wire, $V_C$ denotes a sampling value of a phase voltage of the phase-C wire, $V_X$ denotes a sampling value of a zero sequence voltage of the neutral point of the isolated neutral system, $C_A$ denotes a capacitance value of the phase-A wire, $C_B$ denotes a capacitance value of the phase-B wire, $C_C$ denotes a capacitance value of the phase-C wire, j denotes the imaginary number symbol, and $\omega$ denotes an angular frequency of the isolated neutral system.

The inventor found, through creative efforts, that after the foregoing formula is divided by $j\omega C_A$, the foregoing formula (1.1) is rewritten into the following formula (1.2):

$$V_X\left(1 + \frac{C_B + C_C}{C_A}\right) - 3V_0 + V_B\left(1 - \frac{C_B}{C_A}\right) + V_C\left(1 - \frac{C_C}{C_A}\right) = 0 \qquad (1.2)$$

Assuming that $K_{AB} = \frac{C_B}{C_A}$, $K_{AC} = \frac{C_C}{C_A}$ and $3V_0 = (V_A + V_B + V_C)$, the foregoing formula (1.2) is rewritten into the following formula (1.3):

$$V_X(1 + K_{AB} + K_{AC}) - 3V_0 + V_B(1 - K_{AB}) + V_C(1 - K_{AC}) = 0 \qquad (1.3)$$

It is assumed that

$$Vop = \frac{1}{3}|Vx(1 + K_{AB} + K_{AC}) - 3V_0 + V_B(1 - K_{AB}) + V_C(1 - K_{AC})|,$$

where $Vop$ denotes the working voltage.

To calculate $K_{AB}$ and $K_{AC}$, $Vop = 0$, that is,
$|Vx(1 + K_{AB} + K_{AC}) - 3V_0 + V_B(1 - K_{AB}) + V_C(1 - K_{AC})| = 0$. In this way, the foregoing formula (1.3) is rewritten into the following formula (1.4):

$$K_{AB}(V_X - V_B) + K_{AC}(V_X - V_C) = 3V_0 - (V_X + V_B + V_C) \quad (1.4)$$

Assuming that $x_1 = (V_X - V_B)$, $x_2 = (V_X - V_C)$, $y = 3V_0 - (V_X + V_B + V_C) = V_A - V_X$, $a = K_{AB}$, and $b = K_{AC}$, the foregoing formula (1.4) is rewritten into $ax_1 + bx_2 = y$. According to this formula, assuming that a value of $x_1$ obtained in the first measurement is $x_{11}$ and $x_{21}$, a value of $x_1$ obtained in the second measurement is $x_{12}$ and $x_{22}$, and by analogy, after a total of five measurements, the following formulas are obtained:

$$ax_{11} + bx_{21} = y_1$$

$$ax_{12} + bx_{22} = y_2$$

$$ax_{13} + bx_{23} = y_3$$

$$ax_{14} + bx_{24} = y_4$$

$$ax_{15} + bx_{25} = y_5$$

The foregoing formulas are rewritten into the following matrix formula (1.5):

$$\begin{bmatrix} x_{11} & x_{21} \\ x_{12} & x_{22} \\ x_{13} & x_{23} \\ x_{14} & x_{24} \\ x_{15} & x_{25} \end{bmatrix} \cdot \begin{bmatrix} a \\ b \end{bmatrix} = \begin{bmatrix} y_1 \\ y_2 \\ y_3 \\ y_4 \\ y_5 \end{bmatrix} \quad (1.5)$$

$$X = \begin{bmatrix} x_{11} & x_{21} \\ x_{12} & x_{22} \\ x_{13} & x_{23} \\ \cdots & \cdots \\ x_{1n} & x_{2n} \end{bmatrix} \text{ where } X = \begin{bmatrix} x_{11} & x_{21} \\ x_{12} & x_{22} \\ x_{13} & x_{23} \\ \cdots & \cdots \\ x_{1n} & x_{2n} \end{bmatrix}, \quad Y = \begin{bmatrix} y_1 \\ y_2 \\ y_3 \\ \cdots \\ y_n \end{bmatrix}, \text{ and } R = \begin{bmatrix} K_{AB} \\ K_{AC} \end{bmatrix}.$$

In other words, the matrix formula (1.5) is XR = Y

According to the least square method, the following formula (1.6) is obtained according to the matrix formula (1.5):

$$R = ( \quad X'X)^{-1} X' Y \quad (1.6)$$

where $X'$ denotes a transposed matrix of the matrix $X$, $(X'X)^{-1}$ denotes an inverse of $X'X$, and a calculation method thereof belongs to the prior art, and will not be repeated herein. Since a corresponding error may occur in each measurement, a value of R may be finally obtained according to the foregoing matrix formula, and $K_{AB}$ and $K_{AC}$ are further obtained. After the unbalance rates $K_{AB}$ and $K_{AC}$ are put into the foregoing matrix formula (1.5), an accurate value of $Vop$ can be obtained.

The following description is provided by using three measurements as an example.

$$ax_{11} + bx_{21} = y_1$$

$$ax_{12} + bx_{22} = y_2$$

$$ax_{13} + bx_{23} = y_3$$

The foregoing formulas are rewritten into the following formula: XR = Y Since values in the matrices X and Y may be obtained through measurement, a value of R may be determined according to the following formula, that is,

$$R = (X'X)^{-1} X' Y$$

$$X'X = \begin{bmatrix} x_{11} & x_{12} & x_{13} \\ x_{21} & x_{22} & x_{23} \end{bmatrix} \begin{bmatrix} x_{11} & x_{21} \\ x_{12} & x_{22} \\ x_{13} & x_{23} \end{bmatrix} = \begin{bmatrix} x_{11}^2 + x_{12}^2 + x_{13}^2 & x_{11}x_{21} + x_{12}x_{22} + x_{13}x_{23} \\ x_{11}x_{21} + x_{12}x_{22} + x_{13}x_{23} & x_{21}^2 + x_{22}^2 + x_{23}^2 \end{bmatrix}$$

$$(X'X)^{-1} = (\begin{bmatrix} P & Q \\ Q & L \end{bmatrix})^{-1} = \frac{1}{PL - Q^2} \begin{bmatrix} L & -Q \\ -Q & P \end{bmatrix}$$

Assuming that

$$X'Y = \begin{bmatrix} x_{11} & x_{12} & x_{13} \\ x_{21} & x_{22} & x_{23} \end{bmatrix} \begin{bmatrix} y_1 \\ y_2 \\ y_3 \end{bmatrix} = \begin{bmatrix} x_{11}y_1 + x_{12}y_2 + x_{13}y_3 \\ x_{21}y_1 + x_{22}y_2 + x_{23}y_3 \end{bmatrix} = \begin{bmatrix} M \\ N \end{bmatrix}$$

$$R = \frac{1}{PL - Q^2} \begin{bmatrix} L & -Q \\ -Q & P \end{bmatrix} \begin{bmatrix} M \\ N \end{bmatrix} = \frac{1}{PL - Q^2} \begin{bmatrix} LM - QN \\ PN - QM \end{bmatrix}$$

where

$$P = x_{11}^2 + x_{12}^2 + x_{13}^2$$

$$L = x_{21}^2 + x_{22}^2 + x_{23}^2$$

$$Q = x_{11}x_{21} + x_{12}x_{22} + x_{13}x_{23}$$

$$M = x_{11}y_1 + x_{12}y_2 + x_{13}y_3$$

$$N = x_{21}y_1 + x_{22}y_2 + x_{23}y_3$$

$$K_{AB} = \frac{LM - QN}{PL - Q^2}$$

$$K_{AC} = \frac{PN - QM}{PL - Q^2}$$

Since the foregoing variables can be directly obtained through measurement, corresponding values of unbalance rates $K_{AB}$ and $K_{AC}$ can be calculated.

In step 303, the working voltage of the isolated neutral system is determined based on the unbalance rates.

Values in both steps 301 and 302 are determined when no fault occurs in the isolated neutral system, and the working voltage of the isolated neutral system may be subsequently determined in real time based on the unbalance rates that are obtained when no fault occurs, for example, the working voltage may be determined based on the following formula:

$$\frac{1}{3}|V_X(1 + K_{AB} + K_{AC}) - 3V_0 + V_B(1 - K_{AB}) + V_C(1 - K_{AC})|$$

In step 304, whether the working voltage is greater than or equal to a preset threshold is determined, and if it is determined that the working voltage is greater than or equal to the preset threshold, it is determined that an internal fault occurs in the isolated neutral system.

If the working voltage is still 0 or less than the preset threshold, this indicates that no internal fault occurs. If the working voltage is greater than or equal to the preset threshold, this indicates that the internal fault occurs, and a corresponding relay protection apparatus is required to perform an action to eliminate the fault. The preset threshold is, for example, 0.5 V. If the working voltage is less than the preset threshold, this indicates that an external fault occurs.

In this way, whether the internal fault or the external fault occurs may be determined based on the accurate working voltage, to avoid a false action of the relay protection apparatus. When a fault, for example, a breakdown, occurs in a capacitor in a capacitor bank, a capacitance value of a corresponding phase wire is not equal to capacitance values of the other two phase wires, causing a voltage of the corresponding phase wire to be unequal to voltages of the other two phase wires.

According to this embodiment, an actual working voltage can be determined by determining the unbalance rates between the capacitor banks. In this way, the working voltage may be continuously monitored to determine whether a fault occurs in a capacitor in a capacitor bank, and further determine whether a corresponding relay protection apparatus is required to perform an action.

Embodiment 3

This embodiment provides a determining apparatus for a working voltage of an isolated neutral system. A power system includes three phase wires and three capacitor banks. One terminal of each capacitor bank is connected to one phase wire, and the respective other terminals of the capacitor banks are connected to one another to form a neutral point. Each capacitor bank includes a plurality of capacitors, that is, each capacitor bank is composed of a plurality of capacitors connected in series and in parallel.

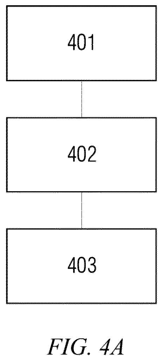

FIG. 4A is a schematic structural diagram of a determining apparatus for a working voltage of an isolated neutral system according to this embodiment. The determining apparatus for a working voltage of an isolated neutral system includes a sampling unit 401, a first determining unit 402, and a second determining unit 403.

The sampling unit 401 is configured to periodically sample a phase voltage of each phase wire, to obtain a plurality of groups of sampling values of real-time phase voltages, where each group of sampling values of real-time phase voltages includes a sampling value of a phase voltage of each phase wire that is obtained by simultaneously measuring each phase wire. The first determining unit 402 is configured to determine unbalance rates between the capacitor banks based on the plurality of groups of sampling values of real-time phase voltages, where the unbalance rate is a ratio between capacitance values of every two phase wires. The second determining unit 403 is configured to determine a working voltage of the isolated neutral system based on the unbalance rates.

Optionally, the first determining unit 402 is specifically configured to:

determine unbalance rates $K_{AB}$ and $K_{AC}$ between the capacitor banks based on the following formula:

$$R = (X'X)^{-1} X' Y$$

$$X = \begin{bmatrix} x_{11} & x_{21} \\ x_{12} & x_{22} \\ x_{13} & x_{23} \\ \cdots & \cdots \\ x_{1n} & x_{2n} \end{bmatrix}$$

$$X = \begin{bmatrix} x_{11} & x_{21} \\ x_{12} & x_{22} \\ x_{13} & x_{23} \\ \cdots & \cdots \\ x_{1n} & x_{2n} \end{bmatrix}, \quad Y = \begin{bmatrix} y_1 \\ y_2 \\ y_3 \\ \cdots \\ y_n \end{bmatrix}, \quad R = \begin{bmatrix} K_{AB} \\ K_{AC} \end{bmatrix}$$

where , , , $x_{1n}$ denotes a value of $x_1$ obtained in the $n^{th}$ measurement, $x_{2n}$ denotes a value of $x_2$ obtained in the $n^{th}$ measurement, $y_n$ denotes a value of $y$ obtained in the $n^{th}$ measurement, $x_1 = (V_X - V_B)$, $x_2 = (V_X - V_C)$, $y = V_A - V_X$, $V_X$ denotes a sampling value of a zero sequence voltage of the neutral point, $V_A$ denotes a sampling value of a phase voltage of a phase-A wire, $V_B$ denotes a sampling value of a phase voltage of a phase-B wire, $V_C$ denotes a sampling value of a phase voltage of a phase-C wire,

EP 4 327 110 B1

$$K_{AB} = \frac{C_B}{C_A}, \quad K_{AC} = \frac{C_C}{C_A}$$ , $C_A$ denotes a capacitance value of the phase-A wire, $C_B$ denotes a capacitance value of the phase-B wire, and $C_C$ denotes a capacitance value of the phase-C wire.

Optionally, the working voltage is

$$\frac{1}{3}\left|V_X(1 + K_{AB} + K_{AC}) - 3V_0 + V_B(1 - K_{AB}) + V_C(1 - K_{AC})\right|,$$

and

$$V_0 = (V_A + V_B + V_C)/3.$$

Optionally, the number of groups of sampling values of real-time phase voltages ranges from 2 to 10.

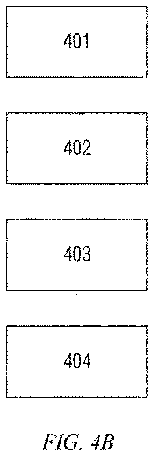

Optionally, as shown in FIG. 4B, the determining apparatus further includes a third determining unit 404, which is configured to: if it is identified that a fault occurs in the isolated neutral system, determine, based on the working voltage, whether the fault is an internal fault, where the internal fault indicates that a fault occurs in a capacitor in the capacitor bank.

The step of determining, based on the working voltage, whether the fault is an internal fault includes:
if a value of the working voltage is greater than or equal to a preset threshold, determining that the fault is an internal fault.

A working method of each unit in this embodiment is the same as that in the foregoing embodiment, and will not be repeated herein.

According to the determining apparatus for a working voltage of an isolated neutral system, the unbalance rates between the capacitor banks are obtained based on the sampling values of the phase voltages measured in real time, and the working voltage is accurately determined based on the unbalance rates, so that subsequent operations can be accurately performed.

The present invention further provides a determining apparatus for a working voltage of an isolated neutral system. A power system includes three phase wires and three capacitor banks. One terminal of each capacitor bank is connected to one phase wire, and the respective other terminals of the capacitor banks are connected to one another to form a neutral point. Each capacitor bank includes a plurality of capacitors connected in series and/or in parallel. The determining apparatus includes at least one memory and at least one processor. The memory is configured to store instructions. The processor is configured to perform, according to the instructions stored in the memory, the determining method for a working voltage of an isolated neutral system according to any one of the foregoing embodiments.

An embodiment of the present invention further provides a readable storage medium. The readable storage medium stores machine-readable instructions that, when executed by a machine, cause the machine to perform the determining method for a working voltage of an isolated neutral system according to any of the foregoing embodiments.

The readable storage medium stores the machine-readable instructions that, when executed by a processor, cause the processor to execute any of the foregoing methods. Specifically, a system or an apparatus with a readable storage medium may be provided, software program code for implementing the functions of any one of the foregoing embodiments is stored in the readable storage medium, and a computer or a processor of the system or apparatus is caused to read and execute the machine-readable instructions stored in the readable storage medium.

In this condition, the program code itself read from the readable storage medium may implement the functions of any one of the foregoing embodiments, and therefore machine-readable code and the readable storage medium storing the machine-readable code constitute a part of the present invention.

The embodiments of the readable storage medium include a floppy disk, a hard disk, a magnetic optical disc, an optical disc (such as CD-ROM, CD-R, CD-RW, DVD-ROM, DVD-RAM, DVD-RW and DVD+RW), a magnetic tape, a non-volatile memory card and a ROM. Optionally, the program code may be downloaded from a server computer or a cloud via a communication network.

It should be understood by those skilled in the art that various variations and modifications may be made to the embodiments disclosed above without departing from the essence of the present invention. Therefore, the protection scope of the present invention shall be limited by the appended claims.

It should be noted that not all the steps and units in the flows and structural diagrams of the system described above are necessary, and some steps or units may be omitted according to practical requirements. The execution order of the various steps is not fixed and may be adjusted according to requirements. A structure of the apparatus described in the foregoing embodiments may be a physical structure, or may be a logical structure. In other words, some units may be implemented by the same physical entity, or some units may be implemented separately by a plurality of physical entities, or may be implemented together by some components in a plurality of independent devices.

In the foregoing embodiments, a hardware unit may be implemented mechanically or electrically. For example, a hardware unit or a processor may include a permanent dedicated circuit or logic (such as a dedicated processor, FPGA or ASIC) to accomplish a corresponding operation. The hardware unit or processor may also include a programmable logic or circuit (such as a general-purpose processor or another programmable processor), and may be set temporarily by software to accomplish a corresponding operation. The specific implementation (mechanical manner, or a dedicated permanent circuit, or a temporarily set circuit) may be de-termined in consideration of cost and time.

The above description is merely illustrative of the preferred embodiments of the present invention and is not intended to limit the present invention. Any modifications, , improvements, and the like made within the principles of the present invention may fall within the protection scope of the present invention as defined by the claims.

**Claims**

1. A determining method for a working voltage of an isolated neutral system, wherein a power system comprises three phase wires and three capacitor banks, one terminal of each capacitor bank is connected to one phase wire, the respective other terminals of the capacitor banks are connected to one another to form a neutral point, and each capacitor bank comprises a plurality of capacitors; and the determining method comprises:

   periodically sampling (201) a phase voltage of each phase wire, to obtain a plurality of groups of sampling values of real-time phase voltages, wherein each group of sampling values of real-time phase voltages comprises a sampling value of a phase voltage of each phase wire that is obtained by simultaneously measuring each phase wire;

   determining (202) unbalance rates between the capacitor banks based on the plurality of groups of sampling values of real-time phase voltages, wherein the unbalance rate is a ratio between capacitance values of every two phase wires; and

   determining (203) a working voltage of the isolated neutral system based on the unbalance rates; **characterized in that**

   the step of determining (202) unbalance rates between the capacitor banks based on the plurality of groups of sampling values of real-time phase voltages comprises:

   determining unbalance rates $K_{AB}$ and $K_{AC}$ between the capacitor banks based on the following formula:

$$R = (\quad X'X)^{-1}X'Y$$

   wherein $X = \begin{bmatrix} x_{11} & x_{21} \\ x_{12} & x_{22} \\ x_{13} & x_{23} \\ \cdots & \cdots \\ x_{1n} & x_{2n} \end{bmatrix}$, $Y = \begin{bmatrix} y_1 \\ y_2 \\ y_3 \\ \cdots \\ y_n \end{bmatrix}$, $R = \begin{bmatrix} K_{AB} \\ K_{AC} \end{bmatrix}$, $x_{1n}$ denotes a value of $x_1$ obtained in the n$^{th}$ measurement, $x_{2n}$ denotes a value of $x_2$ obtained in the n$^{th}$ measurement, $y_n$ denotes a value of $y$ obtained in the n$^{th}$ measurement, $x_1 = (V_X - V_B)$ $x_2 = (V_X - V_C)$, $y = V_A - V_X$, $V_X$ denotes a sampling value of a zero sequence voltage of the neutral point, $V_A$ denotes a sampling value of a phase voltage of a phase-A wire, $V_B$ denotes a sampling value of a phase voltage of a phase-B wire, $V_C$ denotes a sampling value of a phase voltage of a phase-C wire, $K_{AB} = \frac{C_B}{C_A}$, $K_{AC} = \frac{C_C}{C_A}$, $C_A$ denotes a capacitance value of the phase-A wire, $C_B$ denotes a capacitance value of the phase-B wire, and $C_C$ denotes a capacitance value of the phase-C wire.

2. The determining method as claimed in claim 1, wherein the working voltage is

$$\frac{1}{3}\left|V_X(1 + K_{AB} + K_{AC}) - 3V_0 + V_B(1 - K_{AB}) + V_C(1 - K_{AC})\right|$$

   , and $V_0 = (V_A + V_B + V_C)/3$.

3. The determining method as claimed in any one of claims 1 or 2, wherein the number of groups of sampling values of real-time phase voltages ranges from 2 to 10.

4. The determining method as claimed in any one of claims 1 to 3, wherein after the step of determining a working voltage of the isolated neutral system based on the unbalance rates, the determining method further comprises:

   if it is identified that a fault occurs in the isolated neutral system, determining, based on the working voltage, whether the fault is an internal fault, wherein the internal fault indicates that a fault occurs in a capacitor in the capacitor bank; and
   the step of determining, based on the working voltage, whether the fault is an internal fault comprises:
   if a value of the working voltage is greater than or equal to a preset threshold, determining that the fault is an internal fault.

5. A determining apparatus for a working voltage of an isolated neutral system, wherein a power system comprises three phase wires and three capacitor banks, one terminal of each capacitor bank is connected to one phase wire, the respective other terminals of the capacitor banks are connected to one another to form a neutral point, and each capacitor bank comprises a plurality of capacitors; and the determining apparatus comprises:

   a sampling unit (401) configured to periodically sample a phase voltage of each phase wire, to obtain a plurality of groups of sampling values of real-time phase voltages, wherein each group of sampling values of real-time phase voltages comprises a sampling value of a phase voltage of each phase wire that is obtained by simultaneously measuring each phase wire;
   a first determining unit (402) configured to determine unbalance rates between the capacitor banks based on the plurality of groups of sampling values of real-time phase voltages, wherein the unbalance rate is a ratio between capacitance values of every two phase wires; and
   a second determining unit (403) configured to determine a working voltage of the isolated neutral system based on the unbalance rates;
   **characterized in that**
   the first determining unit (402) is specifically configured to:
   determine unbalance rates $K_{AB}$ and $K_{AC}$ between the capacitor banks based on the following formula:

$$R = ( \quad X'X)^{-1} X' Y$$

$$X = \begin{bmatrix} x_{11} & x_{21} \\ x_{12} & x_{22} \\ x_{13} & x_{23} \\ \dots & \dots \\ x_{1n} & x_{2n} \end{bmatrix}, \quad Y = \begin{bmatrix} y_1 \\ y_2 \\ y_3 \\ \dots \\ y_n \end{bmatrix}, \quad R = \begin{bmatrix} K_{AB} \\ K_{AC} \end{bmatrix}$$

wherein , $x_{1n}$ denotes a value of $x_1$ obtained in the $n^{th}$ measurement, $x_{2n}$ denotes a value of $x_2$ obtained in the $n^{th}$ measurement, $y_n$ denotes a value of y obtained in the $n^{th}$ measurement, $x_1 = (V_X - V_B)$, $x_2 = (V_X - V_C)$, $y = V_A - V_X$, $V_X$ denotes a sampling value of a zero sequence voltage of the neutral point, $V_A$ denotes a sampling value of a phase voltage of a phase-A wire, $V_B$ denotes a sampling value of a phase voltage of a phase-B wire, $V_C$ denotes a sampling value of a phase voltage of a phase-C wire,

$$K_{AB} = \frac{c_B}{c_A}, \quad K_{AC} = \frac{c_C}{c_A}$$

, $C_A$ denotes a capacitance value of the phase-A wire, $C_B$ denotes a capacitance value of the phase-B wire, and $C_C$ denotes a capacitance value of the phase-C wire.

6. The determining apparatus as claimed in claim 5, wherein the working voltage is

$$\frac{1}{3}|V_X(1 + K_{AB} + K_{AC}) - 3V_0 + V_B(1 - K_{AB}) + V_C(1 - K_{AC})|$$

, and $V_0 = (V_A + V_B + V_C)/3$.

7. The determining apparatus as claimed in any one of claims 5 or 6, wherein the number of groups of sampling values of real-time phase voltages ranges from 2 to 10.

8. The determining apparatus as claimed in any one of claims 5 to 7, further comprising:

   a third determining unit configured to: if it is identified that a fault occurs in the isolated neutral system, determine, based on the working voltage, whether the fault is an internal fault, wherein the internal fault indicates that a fault occurs in a capacitor in the capacitor bank; and
the step of determining, based on the working voltage, whether the fault is an internal fault comprises:
if a value of the working voltage is greater than or equal to a preset threshold, determining that the fault is an internal fault.

**9.** A determining apparatus for a working voltage of an isolated neutral system, wherein a power system comprises three phase wires and three capacitor banks, one terminal of each capacitor bank is connected to one phase wire, the respective other terminals of the capacitor banks are connected to one another to form a neutral point, and each capacitor bank comprises a plurality of capacitors; and the determining apparatus comprises:

at least one memory configured to store instructions; and
at least one processor configured to perform, according to the instructions stored in the memory, the determining method for a working voltage of an isolated neutral system as claimed in any one of claims 1 to 4.

**10.** A readable storage medium, wherein the readable storage medium stores machine-readable instructions that, when executed by a machine, cause the machine to perform the determining method for a working voltage of an isolated neutral system as claimed in any one of claims 1 to 4.

**Patentansprüche**

**1.** Bestimmungsverfahren für eine Arbeitsspannung eines isolierten neutralen Systems, wobei ein Leistungssystem drei Phasendrähte und drei Kondensatorbänke umfasst, ein Anschluss jeder Kondensatorbank mit einem Phasendraht verbunden ist, die jeweiligen anderen Anschlüsse der Kondensatorbänke miteinander verbunden sind, um einen neutralen Punkt zu bilden, und jede Kondensatorbank mehrere Kondensatoren umfasst; und das Bestimmungsverfahren umfasst:

periodisches Abtasten (201) einer Phasenspannung jedes Phasendrahts, um mehrere Gruppen von Abtastwerten von Echtzeit-Phasenspannungen zu erhalten, wobei jede Gruppe von Abtastwerten von Echtzeit-Phasenspannungen einen Abtastwert einer Phasenspannung jedes Phasendrahts umfasst, der durch gleichzeitiges Messen jedes Phasendrahts erhalten wird;
Bestimmen (202) von Unsymmetrieraten zwischen den Kondensatorbänken basierend auf den mehreren Gruppen von Abtastwerten von Echtzeit-Phasenspannungen, wobei die Unsymmetrierate ein Verhältnis zwischen Kapazitätswerten von jeweils zwei Phasendrähten ist; und
Bestimmen (203) einer Arbeitsspannung des isolierten neutralen Systems basierend auf den Unsymmetrieraten; **dadurch gekennzeichnet, dass**
der Schritt des Bestimmens (202) von Unsymmetrieraten zwischen den Kondensatorbänken basierend auf den mehreren Gruppen von Abtastwerten von Echtzeit-Phasenspannungen umfasst:
Bestimmen von Unsymmetrieraten $K_{AB}$ und $K_{AC}$ zwischen den Kondensatorbänken basierend auf der folgenden Formel:

$$R = (X'X)^{-1}X'Y$$

$$X = \begin{bmatrix} x_{11} & x_{21} \\ x_{12} & x_{22} \\ x_{13} & x_{23} \\ \cdots & \cdots \\ x_{1n} & x_{2n} \end{bmatrix}, \quad Y = \begin{bmatrix} y_1 \\ y_2 \\ y_3 \\ \cdots \\ y_n \end{bmatrix}, \quad R = \begin{bmatrix} K_{AB} \\ K_{AC} \end{bmatrix}$$

wobei $x_{1n}$ einen Wert von $x_1$ bezeichnet, der in der n-ten Messung erhalten wurde, $x_{2n}$ einen Wert von $x_2$ bezeichnet, der in der n-ten Messung erhalten wurde, $y_n$ einen Wert von $y$ bezeichnet, der in der n-ten Messung erhalten wurde, $x_1 = (V_X - V_B)$, $x_2 = (V_X - V_C)$, $y = V_A - V_X$, $V_X$ einen Abtastwert einer Nullsequenzspannung des Neutralpunkts bezeichnet, $V_A$ einen Abtastwert einer Phasenspannung eines Phase-A-Drahts bezeichnet, $V_B$ einen Abtastwert einer Phasenspannung eines Phase-B-Drahts bezeichnet, $V_C$ einen Abtastwert einer Phasenspannung eines Phase-C-Drahts bezeichnet,

$$K_{AB} = \frac{c_B}{c_A}, \quad K_{AC} = \frac{c_C}{c_A},$$

$C_A$ einen Kapazitätswert des Phase-A-Drahts bezeichnet, $C_B$ einen Kapazitätswert des Phase-B-Drahts bezeichnet und $C_C$ einen Kapazitätswert des Phase-C-Drahts bezeichnet.

2. Bestimmungsverfahren nach Anspruch 1, wobei die Arbeitsspannung

$$\frac{1}{3}|V_X(1 + K_{AB} + K_{AC}) - 3V_0 + V_B(1 - K_{AB}) + V_C(1 - K_{AC})|$$

ist und $V_0 = (V_A + V_B + V_C)/3$ ist.

3. Bestimmungsverfahren nach einem der Ansprüche 1 oder 2, wobei die Anzahl von Gruppen von Abtastwerten von Echtzeit-Phasenspannungen im Bereich von 2 bis 10 liegt.

4. Bestimmungsverfahren nach einem der Ansprüche 1 bis 3, wobei nach dem Schritt des Bestimmens einer Arbeitsspannung des isolierten neutralen Systems basierend auf den Unsymmetrieraten das Bestimmungsverfahren ferner umfasst:

falls erkannt wird, dass ein Fehler in dem isolierten neutralen System auftritt, Bestimmen, basierend auf der Arbeitsspannung, ob der Fehler ein interner Fehler ist, wobei der interne Fehler anzeigt, dass ein Fehler in einem Kondensator in der Kondensatorbank auftritt; und
der Schritt des Bestimmens, basierend auf der Arbeitsspannung, ob der Fehler ein interner Fehler ist, umfasst: wenn ein Wert der Arbeitsspannung größer oder gleich einem vorgegebenen Schwellenwert ist, bestimmen, dass der Fehler ein interner Fehler ist.

5. Bestimmungseinrichtung für eine Arbeitsspannung eines isolierten neutralen Systems, wobei ein Leistungssystem drei Phasendrähte und drei Kondensatorbänke umfasst, ein Anschluss jeder Kondensatorbank mit einem Phasendraht verbunden ist, die jeweiligen anderen Anschlüsse der Kondensatorbänke miteinander verbunden sind, um einen neutralen Punkt zu bilden, und jede Kondensatorbank mehrere Kondensatoren umfasst; und die Bestimmungseinrichtung umfasst:

eine Abtasteinheit (401), die dazu ausgelegt ist, periodisch eine Phasenspannung jedes Phasendrahts abzutasten, um mehrere Gruppen von Abtastwerten von Echtzeit-Phasenspannungen zu erhalten, wobei jede Gruppe von Abtastwerten von Echtzeit-Phasenspannungen einen Abtastwert einer Phasenspannung jedes Phasendrahts umfasst, der durch gleichzeitiges Messen jedes Phasendrahts erhalten wird;
eine erste Bestimmungseinheit (402), die dazu ausgelegt ist, Unsymmetrieraten zwischen den Kondensatorbänken basierend auf den mehreren Gruppen von Abtastwerten von Echtzeit-Phasenspannungen zu bestimmen, wobei die Unsymmetrierate ein Verhältnis zwischen Kapazitätswerten von jeweils zwei Phasendrähten ist; und
eine zweite Bestimmungseinheit (403), die dazu ausgelegt ist, eine Arbeitsspannung des isolierten neutralen Systems basierend auf den Unsymmetrieraten zu bestimmen; **dadurch gekennzeichnet, dass**
die erste Bestimmungseinheit (402) speziell ausgelegt ist zum:
Bestimmen von Unsymmetrieraten $K_{AB}$ und $K_{AC}$ zwischen den Kondensatorbänken basierend auf der folgenden Formel:

$$R = (X'X)^{-1}X'Y$$

$$X = \begin{bmatrix} x_{11} & x_{21} \\ x_{12} & x_{22} \\ x_{13} & x_{23} \\ \cdots & \cdots \\ x_{1n} & x_{2n} \end{bmatrix}, \quad Y = \begin{bmatrix} y_1 \\ y_2 \\ y_3 \\ \cdots \\ y_n \end{bmatrix}, \quad R = \begin{bmatrix} K_{AB} \\ K_{AC} \end{bmatrix}$$

wobei $x_{1n}$ einen Wert von $x_1$ bezeichnet, der in der n-ten Messung erhalten wurde, $x_{2n}$ einen Wert von $x_2$ bezeichnet, der in der n-ten Messung erhalten wurde, $y_n$ einen Wert von $y$ bezeichnet, der in der n-ten Messung erhalten wurde, $x_1 = (V_X - V_B)$ $x_2 = (V_X - V_C)$, $y = V_A - V_X$, $V_X$ einen Abtastwert einer Nullsequenzspannung des Neutralpunkts bezeichnet, $V_A$ einen Abtastwert einer Phasenspannung eines Phase-A-Drahts bezeichnet, $V_B$ einen Abtastwert einer Phasenspannung eines Phase-B-Drahts bezeichnet, $V_C$ einen Abtastwert einer Phasenspannung eines Phase-C-Drahts bezeichnet,

$$K_{AB} = \frac{c_B}{c_A}, \quad K_{AC} = \frac{c_C}{c_A}$$

, $C_A$ einen Kapazitätswert des Phase-A-Drahts bezeichnet, $C_B$ einen Kapazitätswert des Phase-B-Drahts bezeichnet und $C_C$ einen Kapazitätswert des Phase-C-Drahts bezeichnet.

6. Bestimmungseinrichtung nach Anspruch 5, wobei die Arbeitsspannung

$$\frac{1}{3}|V_X(1 + K_{AB} + K_{AC}) - 3V_0 + V_B(1 - K_{AB}) + V_C(1 - K_{AC})|$$

und $V_0 = (V_A + V_B + V_C)/3$ ist.

7. Bestimmungseinrichtung nach einem der Ansprüche 5 oder 6, wobei die Anzahl von Gruppen von Abtastwerten von Echtzeit-Phasenspannungen im Bereich von 2 bis 10 liegt.

8. Bestimmungseinrichtung nach einem der Ansprüche 5-7, ferner umfassend:

eine dritte Bestimmungseinheit, die dazu ausgelegt ist: falls identifiziert wird, dass ein Fehler in dem isolierten neutralen System auftritt, basierend auf der Arbeitsspannung zu bestimmen, ob der Fehler ein interner Fehler ist, wobei der interne Fehler angibt, dass ein Fehler in einem Kondensator in der Kondensatorbank auftritt; und der Schritt des Bestimmens, basierend auf der Arbeitsspannung, ob der Fehler ein interner Fehler ist, umfasst: wenn ein Wert der Arbeitsspannung größer oder gleich einem vorgegebenen Schwellenwert ist, bestimmen, dass der Fehler ein interner Fehler ist.

9. Bestimmungseinrichtung für eine Arbeitsspannung eines isolierten neutralen Systems, wobei ein Leistungssystem drei Phasendrähte und drei Kondensatorbänke umfasst, ein Anschluss jeder Kondensatorbank mit einem Phasendraht verbunden ist, die jeweiligen anderen Anschlüsse der Kondensatorbänke miteinander verbunden sind, um einen neutralen Punkt zu bilden, und jede Kondensatorbank mehrere Kondensatoren umfasst; und die Bestimmungseinrichtung umfasst:

wenigstens einen Speicher, der dafür ausgelegt ist, Anweisungen zu speichern; und
wenigstens einen Prozessor, der dazu ausgelegt ist, gemäß den im Speicher gespeicherten Anweisungen das Bestimmungsverfahren für eine Arbeitsspannung eines isolierten neutralen Systems nach einem der Ansprüche 1 bis 4 durchzuführen.

10. Lesbares Speichermedium, wobei das lesbare Speichermedium maschinenlesbare Anweisungen speichert, die, wenn sie durch eine Maschine ausgeführt werden, die Maschine veranlassen, das Bestimmungsverfahren für eine Arbeitsspannung eines isolierten neutralen Systems nach einem der Ansprüche 1 bis 4 durchzuführen.

**Revendications**

1. Procédé de détermination d'une tension de travail d'un système neutre isolé, dans lequel un système d'alimentation comprend trois fils de phase et trois bancs de condensateurs, une borne de chaque banc de condensateurs étant connectée à un fil de phase, les autres bornes respectives des bancs de condensateurs étant connectées les unes aux autres pour former un point neutre, et chaque banc de condensateurs comprenant une pluralité de condensateurs ; et le procédé de détermination comprend :

l'échantillonnage périodiquement (201) d'une tension de phase de chaque fil de phase, afin d'obtenir une pluralité de groupes de valeurs d'échantillonnage de tensions de phase en temps réel, chaque groupe de valeurs d'échantillonnage de tensions de phase en temps réel comprenant une valeur d'échantillonnage d'une tension de phase de chaque fil de phase obtenue en mesurant simultanément chaque fil de phase ;
la détermination (202) de taux de déséquilibre entre les bancs de condensateurs sur la base de la pluralité de groupes de valeurs d'échantillonnage de tensions de phase en temps réel, le taux de déséquilibre étant un rapport entre des valeurs de capacité de chaque fil de deux phases ; et
la détermination (203) d'une tension de travail du système neutre isolé sur la base des taux de déséquilibre ;
**caractérisé en ce que**
l'étape de détermination (202) des taux de déséquilibre entre les bancs de condensateurs sur la base de la pluralité de groupes de valeurs d'échantillonnage de tensions de phase en temps réel comprend :
la détermination de taux de déséquilibre $K_{AB}$ et $K_{AC}$ entre les bancs de condensateurs à l'aide de la formule suivante :

$$R = (\quad X'X)^{-1}X'Y$$

où $X = \begin{bmatrix} x_{11} & x_{21} \\ x_{12} & x_{22} \\ x_{13} & x_{23} \\ \cdots & \cdots \\ x_{1n} & x_{2n} \end{bmatrix}$, $Y = \begin{bmatrix} y_1 \\ y_2 \\ y_3 \\ \cdots \\ y_n \end{bmatrix}$, $R = \begin{bmatrix} K_{AB} \\ K_{AC} \end{bmatrix}$, $x_{1n}$ désigne une valeur de $x_1$ obtenue dans la $n^{ième}$ mesure, $x_{2n}$ désigne une valeur de $x_2$ obtenue dans la $n^{ième}$ mesure, $y_n$ désigne une valeur de $y$ obtenue dans la $n^{ième}$ mesure, $x_1 = (V_X - V_B)$, $x_2 = (V_X - V_C)$, $- V_A - V_X$, $V_X$ désigne une valeur d'échantillonnage d'une tension homopolaire du point neutre, $V_A$ désigne une valeur d'échantillonnage d'une tension de phase d'un fil de phase A, $V_B$ désigne une valeur d'échantillonnage d'une tension de phase d'un fil de phase B, $V_C$ désigne une valeur d'échantillonnage d'une tension de phase d'un fil de phase C, $K_{AB} = \frac{c_B}{c_A}$, $K_{AC} = \frac{c_C}{c_A}$, $C_A$ *désigne* une valeur de capacité du fil de phase A, $C_B$ désigne une valeur de capacité du fil de phase B, et $C_C$ désigne une valeur de capacité du fil de phase C.

2. Procédé de détermination selon la revendication 1, dans lequel la tension $\frac{1}{3}|V_X(1 + K_{AB} + K_{AC}) - 3V_0 + V_B(1 - K_{AB}) + V_C(1 - K_{AC})|$ de travail est , et $V_0 = (V_A + V_B + V_C)/3$.

3. Procédé de détermination selon l'une quelconque des revendications 1 ou 2, dans lequel le nombre de groupes de valeurs d'échantillonnage de tensions de phase en temps réel est compris entre 2 et 10.

4. Procédé de détermination selon l'une quelconque des revendications 1 à 3, dans lequel, après l'étape de détermination d'une tension de travail du système neutre isolé sur la base des taux de déséquilibre, le procédé de détermination comprend en outre :

   s'il est identifié qu'un défaut se produit dans le système neutre isolé, la détermination, sur la base de la tension de travail, si le défaut est un défaut interne, le défaut interne indiquant qu'un défaut se produit dans un condensateur du banc de condensateurs ; et
   l'étape de détermination, sur la base de la tension de travail, si le défaut est un défaut interne comprenant :
   si une valeur de la tension de travail est supérieure ou égale à un seuil prédéfini, déterminer que le défaut est un défaut interne.

5. Appareil de détermination d'une tension de travail d'un système neutre isolé, dans lequel un système d'alimentation comprend trois fils de phase et trois bancs de condensateurs, une borne de chaque banc de condensateurs étant connectée à un fil de phase, les autres bornes respectives des bancs de condensateurs étant connectées les unes aux autres pour former un point neutre, et chaque banc de condensateurs comprenant une pluralité de condensateurs ; et l'appareil de détermination comprend :

   une unité d'échantillonnage (401) configurée pour échantillonner périodiquement une tension de phase de chaque fil de phase, afin d'obtenir une pluralité de groupes de valeurs d'échantillonnage de tensions de phase en temps réel, chaque groupe de valeurs d'échantillonnage de tensions de phase en temps réel comprenant une valeur d'échantillonnage d'une tension de phase de chaque fil de phase obtenue en mesurant simultanément chaque fil de phase ;
   une première unité de détermination (402) configurée pour déterminer des taux de déséquilibre entre les bancs de condensateurs sur la base de la pluralité de groupes de valeurs d'échantillonnage de tensions de phase en temps réel, le taux de déséquilibre étant un rapport entre des valeurs de capacité de chaque fil de deux phases ; et
   une deuxième unité de détermination (403) configurée pour déterminer une tension de travail du système neutre isolé sur la base des taux de déséquilibre ; **caractérisée en ce que**
   la première unité de détermination (402) est spécifiquement configurée pour :
   déterminer des taux de déséquilibre $K_{AB}$ et $K_{AC}$ entre les bancs de condensateurs à l'aide de la formule suivante :

$$R = (\quad X'X)^{-1} X' Y$$

où $X = \begin{bmatrix} x_{11} & x_{21} \\ x_{12} & x_{22} \\ x_{13} & x_{23} \\ \cdots & \cdots \\ x_{1n} & x_{2n} \end{bmatrix}$, $Y = \begin{bmatrix} y_1 \\ y_2 \\ y_3 \\ \cdots \\ y_n \end{bmatrix}$, $R = \begin{bmatrix} K_{AB} \\ K_{AC} \end{bmatrix}$, $x_{1n}$ désigne une valeur de $x_1$ obtenue dans la $n^{\text{ième}}$ mesure, $x_{2n}$ désigne une valeur de $x_2$ obtenue dans la $n^{\text{ième}}$ mesure, $y_n$ désigne une valeur de $y$ obtenue dans la $n^{\text{ième}}$ mesure, $x_1 = (V_X - V_B)$, $x_2 = (V_X - V_C)$, $y = V_A - V_X$, $V_X$ désigne une valeur d'échantillonnage d'une tension homopolaire du point neutre, $V_A$ désigne une valeur d'échantillonnage d'une tension de phase d'un fil de phase A, $V_B$ désigne une valeur d'échantillonnage d'une tension de phase d'un fil de phase B, $V_C$ désigne une valeur d'échantillonnage d'une tension de phase d'un fil de phase C, $K_{AB} = \frac{c_B}{c_A}$, $K_{AC} = \frac{c_C}{c_A}$, $C_A$ désigne une valeur de capacité du fil de phase A, $C_B$ désigne une valeur de capacité du fil de phase B, et $C_C$ désigne une valeur de capacité du fil de phase C.

6. Appareil de détermination selon la revendication 5, dans lequel la tension de travail est $\frac{1}{3}|V_X(1 + K_{AB} + K_{AC}) - 3V_0 + V_B(1 - K_{AB}) + V_C(1 - K_{AC})|$, et $V_0 = (V_A + V_B + V_C)/3$.

7. Appareil de détermination selon l'une quelconque des revendications 5 ou 6, dans lequel le nombre de groupes de valeurs d'échantillonnage de tensions de phase en temps réel est compris entre 2 et 10.

8. Appareil de détermination selon l'une quelconque des revendications 5 à 7, comprenant en outre :

   une troisième unité de détermination configurée pour : s'il est identifié qu'un défaut se produit dans le système neutre isolé, déterminer, sur la base de la tension de travail, si le défaut est un défaut interne, le défaut interne indiquant qu'un défaut se produit dans un condensateur du banc de condensateurs ; et
   l'étape de détermination, sur la base de la tension de travail, si le défaut est un défaut interne comprenant :
   si une valeur de la tension de travail est supérieure ou égale à un seuil prédéfini, déterminer que le défaut est un défaut interne.

9. Appareil de détermination d'une tension de travail d'un système neutre isolé, dans lequel un système d'alimentation comprend trois fils de phase et trois bancs de condensateurs, une borne de chaque banc de condensateurs étant connectée à un fil de phase, les autres bornes respectives des bancs de condensateurs étant connectées les unes aux autres pour former un point neutre, et chaque banc de condensateurs comprenant une pluralité de condensateurs ; et l'appareil de détermination comprend :

   au moins une mémoire configurée pour stocker des instructions ; et
   au moins un processeur configuré pour exécuter, selon les instructions stockées dans la mémoire, le procédé de détermination d'une tension de travail d'un système neutre isolé selon l'une quelconque des revendications 1 à 4.

10. Support de stockage lisible, dans lequel le support de stockage lisible stocke des instructions lisibles par machine qui, lorsqu'elles sont exécutées par une machine, amènent la machine à exécuter le procédé de détermination d'une tension de travail d'un système neutre isolé selon l'une quelconque des revendications 1 à 4.

*FIG. 1*

FIG. 2

*FIG. 3*

```
┌─────────────────┐
│                 │
│       401       │
│                 │
└─────────────────┘
         │
┌─────────────────┐
│                 │
│       402       │
│                 │
└─────────────────┘
         │
┌─────────────────┐
│                 │
│       403       │
│                 │
└─────────────────┘
```

*FIG. 4A*

```
┌─────────────────────┐
│                     │
│         401         │
│                     │
└─────────────────────┘
           │
┌─────────────────────┐
│                     │
│         402         │
│                     │
└─────────────────────┘
           │
┌─────────────────────┐
│                     │
│         403         │
│                     │
└─────────────────────┘
           │
┌─────────────────────┐
│                     │
│         404         │
│                     │
└─────────────────────┘
```

*FIG. 4B*

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **JOUYBARI-MOGHADDAM HESSAMODDIN et al.** Shunt Capacitor Banks Online Monitoring Using a Superimposed Reactance Method. *IEEE Transactions on Smart Grid*
- **TERRENCE SMITH**. Determining settings for capacitor bank protection. *Protective Relay Engineers*, 2010
- **BOGDAN KASZTENNY et al.** Fundamentals of adaptiveprotection of large capacitor banks. *Power Systems Conference: Advanced Metering, Protection, Control, Communication, And Distributed Resources*